# EUROPEAN PATENT APPLICATION

(11) **EP 4 557 001 A2**
(43) Date of publication of application: **21.05.2025**
(21) Application number: 24201090.8
(22) Date of filing: 18.09.2024
(51) Int. Cl.: G03F 1/24, G03F 1/38, G03F 1/48, G03F 1/52, G03F 1/54

(54) **REFLECTIVE PHOTOMASK BLANK WITH A MULTILAYER REFLECTIVE FILM WITH A PERIODIC STACKED STRUCTURE AND MANUFACTURING METHOD THEREOF**

(30) Priority: 30.10.2023 JP 2023185600
(71) Applicant: SHIN-ETSU CHEMICAL CO., LTD., Tokyo 1000005 (JP)
(72) Inventor: OGOSE, Taiga, Niigata, 942-8601 (JP); INAZUKI, Yukio, Niigata, 942-8601 (JP); KANEKO, Hideo, Niigata, 942-8601 (JP); KOSAKA, Takuro, Niigata, 942-8601 (JP)
(74) Representative: Hindles Limited

(57) **Abstract**

A reflective photomask blank has a substrate 10; and a multilayer reflective film 50. The multilayer reflective film 50 has a periodic stacked structure in which a low refractive index layer 30 containing ruthenium (Ru), a high refractive index layer 20 containing silicon (Si), and a diffusion prevention layer 40. The diffusion prevention layer 40 is formed in contact with the low refractive index layer 30 on both or one of a side of the low refractive index layer 30 close to the substrate 10 and a side of the low refractive index layer 30 away from the substrate 10. The diffusion prevention layer 40 is one or more sublayers selected from a layer containing a silicon nitride (SiN), a layer containing silicon carbide (SiC), a layer containing molybdenum (Mo), a layer containing a molybdenum nitride (MoN), and a layer containing molybdenum carbide (MoC).

## Description

### Technical Field

The present invention relates to a reflective photomask used for manufacturing a semiconductor device such as an LSI, a reflective photomask blank which is a material for such a reflective photomask, and a method for manufacturing a reflective photomask blank.

### Background Art

In the process of manufacturing a semiconductor device, a photolithography technique of irradiating a transfer mask with exposure light and transferring a circuit pattern formed on the mask onto a semiconductor substrate (semiconductor wafer) through a reduction projection optical system is repeatedly used. Conventionally, a mainstream wavelength of the exposure light is 193 nm by argon fluoride (ArF) excimer laser light, and a pattern with dimensions smaller than the exposure wavelength has been finally formed by adopting a process called multi-patterning in which an exposure process and a processing process are combined a plurality of times.

However, since it has been necessary to form finer patterns due to continuous miniaturization of device patterns, an extreme ultraviolet (hereinafter referred to as EUV) lithography technique using EUV light having a wavelength shorter than that of ArF excimer laser light as exposure light has been used. The EUV light is light having a wavelength of about 0.2 nm to 100 nm, more specifically, light having a wavelength of around 13.5 nm. Since the EUV light has extremely low transmittance to a substance so that a conventional transmission type projection optical system or mask cannot be used, a reflective optical element is used. Therefore, a reflective photomask is also used as a mask for pattern transfer.

The reflective photomask in general is configured such that a multilayer reflective film that reflects EUV light is provided on a substrate and a pattern of an absorbing film that absorbs EUV light is formed on the multilayer reflective film. Meanwhile, a state before pattering of the absorbing film (including a state in which a resist film has been formed) is referred to as a reflective photomask blank, and this is used as a material of the reflective photomask.

The reflective photomask blank has a low thermal expansion substrate and a multilayer reflective film that is formed on the substrate and reflects EUV light, and generally has a basic structure having an absorber film that is formed on the multilayer reflective film and absorbs EUV light.

As the multilayer reflective film, a multilayer reflective film that obtains a necessary reflectance for EUV light by alternately stacking a molybdenum (Mo) film and a silicon (Si) film is usually used. Furthermore, as a protective film for protecting the multilayer reflective film, a ruthenium (Ru) film is formed on the outermost layer of the multilayer reflective film. On the other hand, as the absorber film, tantalum (Ta) or the like having a relatively large value of an extinction coefficient with respect to EUV light is used (JP 2002-246299 A).

### SUMMARY OF INVENTION

### PROBLEM TO BE SOLVED BY INVENTION

In EUV lithography, exposure light is obliquely incident on a reflective photomask, and an incident angle thereof is mainly set to six degrees with respect to a normal line of a main surface of the reflective photomask. A part of the obliquely incident exposure light is blocked by a side wall of an absorber pattern, and a so-called 3D effect (three-dimensional effect, shadowing effect) is generated. The 3D effect causes positional deviation and dimensional deviation in a transfer pattern, and it is preferable that the 3D effect is small in pattern miniaturization. As the thickness of the absorber pattern is thinner, the 3D effect is smaller, and thus thinning is desired.

On the other hand, the 3D effect varies depending on the structure of the multilayer reflective film in addition to the thickness of the absorber pattern. Reflection of the exposure light by the multilayer reflective film is caused by superposition of reflections generated from interfaces between layers inside the multilayer reflective film, but a large contribution of reflection from a position deeper than the surface of the multilayer reflective film is a factor of increasing the 3D effect. Therefore, in the multilayer reflective film, it is advantageous for reduction of the 3D effect to relatively increase the contribution of reflection from a position shallow from the surface.

In general, the multilayer reflective film has a periodic stacked structure in which a low refractive index layer and a high refractive index layer are alternately stacked, and a multilayer reflective film (Mo/Si multilayer reflective film) in which molybdenum (Mo) and silicon (Si) are alternately stacked around 40 cycles is known to efficiently reflect EUV light, and is currently used as a mainstream multilayer reflective film in an EUV photomask blank.

Ruthenium (Ru) is a material having a lower refractive index at a wavelength of 13.5 nm and a larger absorption coefficient than molybdenum (Mo). Ruthenium (Ru) has a higher reflection coefficient at an ideal interface with silicon (Si) (interface without interdiffusion or roughness). Therefore, in the multilayer reflective film, when ruthenium (Ru) is used as the low refractive index layer, a contribution of reflection from an interface at a shallow position from the surface of the multilayer reflective film increases, and an increase in reflectance with respect to an increase in the number of layers of the multilayer reflective film is saturated with a smaller number of layers. On the other hand, since the absorption coefficient is larger, the loss due to the absorption effect increases as the number of layers of the multilayer reflective film increases. As a result, when the number of layers of the multilayer reflective film is small, the Ru/Si multilayer reflective film has a higher reflectance, but when the number of layers is increased, the Mo/Si multilayer reflective film tends to have a higher reflectance.

In comparison by the same number of layers, the contribution of reflection from a position closer to the surface is relatively larger in the Ru/Si multilayer reflective film, and the Ru/Si multilayer reflective film is considered to be more advantageous from the viewpoint of the 3D effect.

However, in the Ru/Si multilayer reflective film, ruthenium (Ru) and silicon (Si) are likely to form an interdiffusion layer, the reflectance at each interface decreases, and the expected reflectance cannot be obtained.

### MEANS FOR SOLVING PROBLEM

The inventors of the present application have found that, in a multilayer reflective film in which Ru and Si that contribute greatly to reflection from a shallower position from a surface of the multilayer reflective film are alternately stacked, a diffusion prevention layer that effectively prevents mutual diffusion of Ru and Si is provided to obtain a reflective photomask blank capable of forming a photomask that prevents a decrease in reflectance, improves a 3D effect, and has high contrast, thereby completing the present invention.

A reflective photomask blank according to the present invention may comprise:
a substrate; and
a multilayer reflective film that is formed on one main surface of the substrate and reflects exposure light,
the multilayer reflective film may have a periodic stacked structure in which a low refractive index layer containing ruthenium (Ru), a high refractive index layer containing silicon (Si), and a diffusion prevention layer that prevents mutual diffusion of ruthenium (Ru) and silicon (Si) are periodically stacked,
the diffusion prevention layer may be formed in contact with the low refractive index layer on both or one of a side of the low refractive index layer close to the substrate and a side of the low refractive index layer away from the substrate, and
the diffusion prevention layer may be one or more sublayers selected from a layer containing a silicon nitride (SiN), a layer containing silicon carbide (SiC), a layer containing molybdenum (Mo), a layer containing a molybdenum nitride (MoN), and a layer containing molybdenum carbide (MoC).

In the reflective photomask blank according to the present invention, the low refractive index layer may have a ruthenium content equal to or more than 70 at%.

In the reflective photomask blank according to the present invention,
the diffusion prevention layer may have a first diffusion prevention layer provided in contact with the side of the low refractive index layer close to the substrate,
the first diffusion prevention layer may have a first sublayer formed in contact with the high refractive index layer and a second sublayer formed in contact with the low refractive index layer,
the first sublayer may be a sublayer containing at least one material selected from a silicon nitride (SiN), silicon carbide (SiC), a molybdenum nitride (MoN), and molybdenum carbide (MoC),
the second sublayer may be a sublayer containing molybdenum (Mo), and
the second sublayer may have a thickness between 0.2 nm and 0.8 nm.

In the reflective photomask blank according to the present invention,
the diffusion prevention layer may have a second diffusion prevention layer provided in contact with a side of the low refractive index layer away from the substrate, and
the second diffusion prevention layer may have a layer containing molybdenum (Mo) formed in contact with the low refractive index layer, and a thickness of the second diffusion prevention layer is between 0.2 nm and 0.8 nm.

A method for manufacturing a reflective photomask blank according to the present invention may comprise:
forming the multilayer reflective film of the reflective photomask blank according to the present invention by a sputtering film formation method using a sputtering apparatus capable of mounting a plurality of targets in a chamber.

### EFFECT OF INVENTION

According to the present invention, there is provided a reflective photomask blank capable of preventing a decrease in reflectance, reducing a 3D effect, and manufacturing a photomask having high contrast at the time of pattern transfer by providing a diffusion prevention layer that effectively prevents mutual diffusion of Ru and Si in a multilayer reflective film having a structure in which Ru and Si are alternately stacked, which can increase contribution of reflection from a shallower position from a surface of the multilayer reflective film.

### BRIEF DESCRIPTION OF DRAWINGS

FIG. 1A is a longitudinal sectional view illustrating an example in which a first diffusion prevention layer and a second diffusion prevention layer are provided in a reflective photomask blank according to an embodiment of the present invention;
Fig. 1B is a longitudinal sectional view illustrating an example in which a first diffusion prevention layer with a first sublayer and a second sublayer and a second diffusion prevention layer are provided in a reflective photomask blank according to an embodiment of the present invention;
Fig. 2 is a longitudinal sectional view illustrating an example in which a first diffusion prevention layer is provided in a reflective photomask blank according to an embodiment of the present invention;
Fig. 3 is a longitudinal sectional view illustrating an example in which a second diffusion prevention layer is provided in a reflective photomask blank according to an embodiment of the present invention;
Fig. 4 is a longitudinal sectional view illustrating an aspect in which a pattern of an absorber film is formed in a reflective photomask blank according to an embodiment of the present invention;
Fig. 5 is a longitudinal sectional view illustrating an aspect in which an etching mask film is provided in a reflective photomask blank according to an embodiment of the present invention;
Fig. 6 is a longitudinal sectional view illustrating an aspect in which an etching mask film and a resist film are provided in a reflective photomask blank according to an embodiment of the present invention;
Fig. 7 is a longitudinal sectional view illustrating an aspect in which a pattern of an etching mask film is formed by using a resist pattern as an etching mask in a reflective photomask blank according to an embodiment of the present invention;
Fig. 8 is a longitudinal sectional view illustrating Example 1 of the present invention;
Fig. 9 is a longitudinal sectional view illustrating Examples 9 to 12 of the present invention; and
FIG. 10 is a longitudinal sectional view illustrating an aspect in which a high refractive index layer is provided on an uppermost layer of a multilayer reflective film in the aspect illustrated in FIG. 1A.

### DETAILED DESCRIPTION

The following is a more detailed description of the invention.

A reflective photomask blank according to the present embodiment has a substrate 10 and a multilayer reflective film 50 formed on the substrate 10 (on one main surface (front surface) of the substrate 10) that reflects exposure light. The reflective photomask blank is suitable as a material of a reflective photomask (EUV mask) used in EUV lithography in which EUV light is used as exposure light. The EUV light used in the EUV lithography in which the EUV light is used as the exposure light has a wavelength of 13 nm to 14 nm, and is usually light having a wavelength of about 13.5 nm.

The substrate 10 preferably has low thermal expansion characteristics for use in exposure to EUV light, and for example, is preferably made of a material having a thermal expansion coefficient within a range of ± 2 × 10⁻⁸/°C, preferably within a range of ± 5 × 10⁻⁹/°C. Examples of such a material include titania-doped quartz glass (SiO₂-TiO₂-based glass). In addition, it is preferable to use the substrate 10 whose surface is sufficiently planarized, and a surface roughness of the main surface of the substrate 10 is preferably 0.5 nm or less, more preferably 0.2 nm or less in RMS value. Such a surface roughness can be obtained by polishing the substrate 10 or the like. The substrate 10 preferably has a size in which a size of the main surface of the substrate 10 is 152 mm square and a thickness of the substrate 10 is 6.35 mm. The substrate 10 having such a size is a substrate referred to as a so-called 6025 substrate (substrate having a main surface size of 6 inch square and a thickness of 0.25 inch).

The multilayer reflective film 50 is a film that reflects EUV light that is exposure light in the reflective photomask. The multilayer reflective film 50 may be provided in contact with one main surface of the substrate 10, and a base film (not illustrated) may be provided between the substrate 10 and the multilayer reflective film 50. The multilayer reflective film 50 is a film that reflects EUV light that is exposure light in the reflective photomask. The multilayer reflective film 50 has a periodic stacked structure in which a high refractive index layer 20 having a relatively high refractive index to EUV light and a low refractive index layer 30 having a relatively low refractive index to EUV light are alternately stacked. The number of cycles of the periodic stacked structure is preferably equal to or more than 10, particularly preferably equal to or more than 20 cycles, and preferably equal to or less than 50 cycles, particularly preferably equal to or less than 40 cycles, further preferably equal to or less than 30 cycles. The value of the reflectance is preferably equal to or more than 50%, particularly preferably equal to or more than 55%, further preferably equal to or more than 60%.

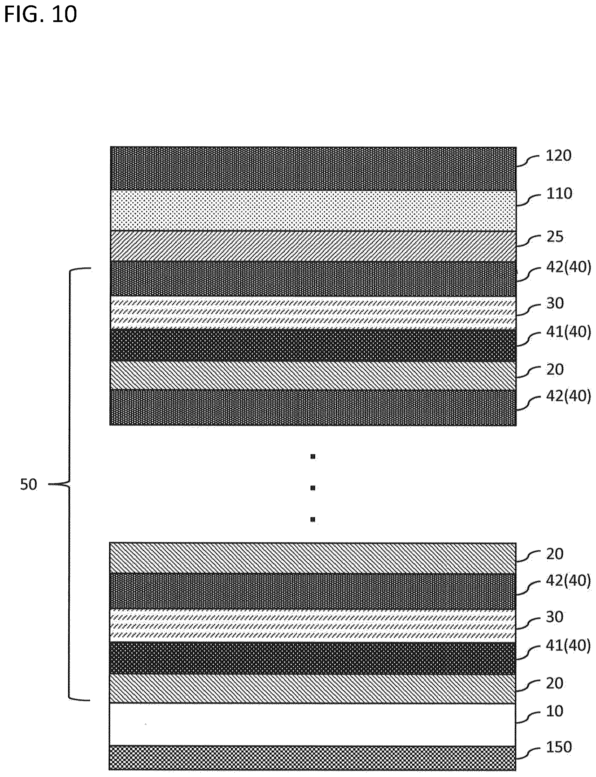

In addition, the uppermost layer of the multilayer reflective film 50 may be a protective layer having a function of protecting the multilayer reflective film 50. At this time, a high refractive index layer (see a layer indicated by reference numeral 25 in FIG. 10) may be provided on the uppermost layer of the multilayer reflective film 50, and the high refractive index layer may have a function of protecting the multilayer reflective film 50. In a case where the high refractive index layer is provided on the uppermost layer of the multilayer reflective film 50 as described above, a protective film 110, an absorber film 120, and the like described later are provided on the high refractive index layer.

The multilayer reflective film 50 of the present embodiment has a layer containing silicon (Si) as the high refractive index layer 20 and a layer containing ruthenium (Ru) as the low refractive index layer 30, and further has a diffusion prevention layer 40 that prevents interdiffusion of silicon (Si) and ruthenium (Ru).

The high refractive index layer 20 contains silicon (Si), may contain at least one additive element selected from oxygen (O), nitrogen (N), carbon (C), boron (B), and hydrogen (H), and may be constituted by a multilayer of a layer containing additive elements and a layer not containing additive elements. The thickness of the high refractive index layer 20 is preferably equal to or more than 2.5 nm and equal to or less than 5.5 nm, and more preferably equal to or more than 3 nm and equal to or less than 5 nm.

The low refractive index layer 30 is formed by a material containing ruthenium (Ru), and can be formed by ruthenium (Ru) alone, an alloy of ruthenium (Ru) and molybdenum (Mo), or the like. The ruthenium content of the low refractive index layer 30 is preferably equal to or more than 70 at%, and more preferably equal to or more than 80 at%. By increasing the ruthenium content of the low refractive index layer 30, the refractive index of the low refractive index layer 30 can be further decreased, and contribution of reflection from a shallower position from the surface of the multilayer reflective film 50 can be increased. The thickness of the low refractive index layer 30 is preferably equal to or more than 1 nm and equal to or less than 4 nm, and more preferably equal to or more than 1.5 nm and equal to or less than 3.5 nm.

The diffusion prevention layer 40 has an effect of preventing mutual diffusion of ruthenium (Ru) and silicon (Si), and includes one or more sublayers selected from a layer containing a silicon nitride (SiN), a layer containing silicon carbide (SiC), a layer containing molybdenum (Mo), a layer containing a molybdenum nitride (MoN), and a layer containing molybdenum carbide (MoC). The diffusion prevention layer 40 may further contain hydrogen (H), boron (B), and oxygen (O). The thickness of the diffusion prevention layer 40 is preferably equal to or more than 0.2 nm and equal to or less than 1.3 nm.

The diffusion prevention layer 40 can be provided at one interface portion of the side close to the substrate 10 or the side away from the substrate 10 of the low refractive index layer 30, or at both interface portions, but is preferably provided at both interface portions. In a case where the diffusion prevention layer 40 is provided at both interface portions of the low refractive index layer 30, the number, the material, and the thickness of the sublayers constituting the diffusion prevention layer 40 may be the same or different. In addition, the diffusion prevention layer 40 in one multilayer reflective film 50 may be the same or different in the number of sublayers constituting each layer, the material thereof, and the thickness thereof.

For example, in a case where the diffusion prevention layer 40 includes only one sublayer, the diffusion prevention layer 40 only needs to be formed in contact with the low refractive index layer 30 on one or both of the side close to the substrate 10 and the side away from the substrate 10 of at least one low refractive index layer 30 of the multilayer reflective film 50.

Alternatively, when the diffusion prevention layer 40 including two sublayers is provided, the diffusion prevention layer 40 including a first sublayer 46 and a second sublayer 47 only needs to be formed in contact with the low refractive index layer 30 on one or both of the side close to the substrate 10 and the side away from the substrate 10 of at least one low refractive index layer 30 of the multilayer reflective film 50.

The diffusion prevention layer 40 is preferably provided on both the side of the low refractive index layer 30 close to the substrate 10 and the side away from the substrate 10.

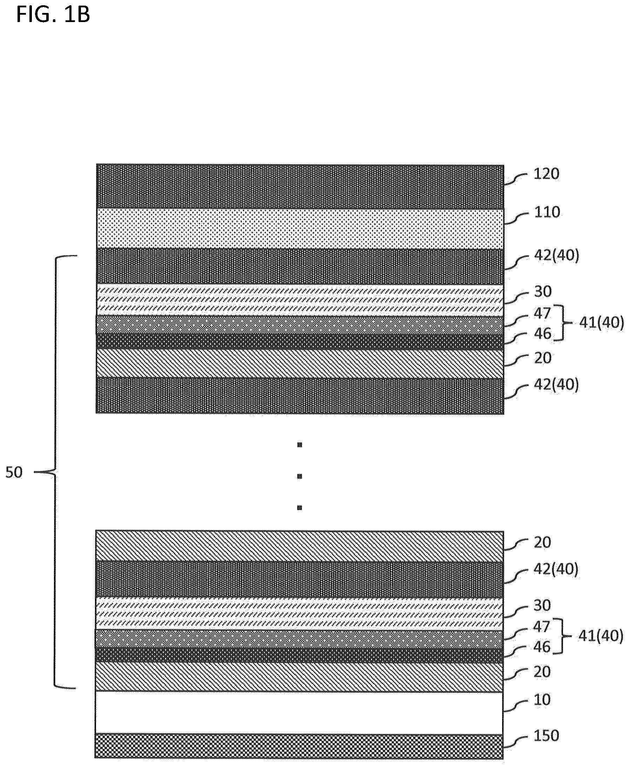

The diffusion prevention layer 40 provided on the side of the low refractive index layer 30 close to the substrate 10 is referred to as a first diffusion prevention layer 41 in the present embodiment. The first diffusion prevention layer 41 preferably includes a first sublayer 46 formed in contact with the high refractive index layer 20 and a second sublayer 47 formed in contact with the low refractive index layer 30 (see FIG. 1B). At this time, it is preferable that the first sublayer 46 is a sublayer containing at least one material selected from a silicon nitride (SiN), silicon carbide (SiC), a molybdenum nitride (MoN), and molybdenum carbide (MoC), and the second sublayer 47 is a sublayer containing molybdenum (Mo). It is effective that the material of the second sublayer 47 is molybdenum (Mo) that is a material having a low refractive index of EUV light and a small absorption coefficient, which is particularly difficult to form an interdiffusion layer with ruthenium (Ru). The first sublayer 46 has an effect of preventing molybdenum (Mo) from diffusing into the silicon (Si) layer when forming the diffusion prevention layer 40 containing molybdenum (Mo) after forming the high refractive index layer 20 containing silicon (Si), and a silicon nitride (SiN), silicon carbide (SiC), a molybdenum nitride (MoN), molybdenum carbide (MoC), or the like is effective as a material thereof.

In such a configuration, the thickness of the second sublayer 47 is preferably equal to or more than 0.2 nm and equal to or less than 0.8 nm. By doing so, the contribution of reflection from a shallower position from the surface of the multilayer reflective film 50 can be kept large (the depth of the effective reflective surface becomes shallow).

The diffusion prevention layer 40 provided on the side of the low refractive index layer 30 away from the substrate 10 is referred to as a second diffusion prevention layer 42 in the present embodiment. The second diffusion prevention layer 42 is preferably a layer containing molybdenum (Mo), and the thickness thereof is preferably equal to or more than 0.2 nm and equal to or less than 0.8 nm from the viewpoint of the reflectance and the effective reflection surface depth of the multilayer reflective film 50.

Examples of a method for forming the multilayer reflective film 50 include a sputtering method in which power is supplied to a target, an atmospheric gas is converted into plasma (ionized) with the supplied power, and sputtering is performed, and an ion beam sputtering method in which a target is irradiated with an ion beam. Examples of the sputtering method include a DC sputtering method in which a DC voltage is applied to a target, and an RF sputtering method in which a radio frequency voltage is applied to a target. The sputtering method is a film forming method that utilizes a sputtering phenomenon of gas ions by applying a voltage to a target in a state where a sputtering gas is introduced into a chamber to ionize the gas and a sputtering phenomenon by gas ions is used. In particular, a magnetron sputtering method is advantageous in terms of productivity. The power applied to a target may be DC or RF, and the case of DC also includes pulse sputtering that inverts a negative bias applied to a target for a short time to prevent charge-up of the target.

The multilayer reflective film 50 can be formed, for example, by a sputtering method using a sputtering apparatus on which a plurality of targets can be mounted. Specifically, the multilayer reflective film 50 can be formed by using targets appropriately selected from a ruthenium (Ru) target for forming a layer containing ruthenium (Ru), a silicon (Si) target for forming a layer containing silicon (Si), a molybdenum (Mo) target for forming a layer containing molybdenum (Mo), and the like and using a rare gas such as a Neon (Ne) gas, an argon (Ar) gas, a krypton (Kr) gas, or a xenon (Xe) gas as the sputtering gas.

When a layer containing molybdenum carbide (MoC) or a layer containing silicon carbide (SiC) is formed, the layer can be formed by using a carbon (C) target and applying a voltage simultaneously with or separately from a molybdenum (Mo) target or a silicon (Si) target. Alternatively, it can be formed using a molybdenum (Mo) target to which carbon (C) is added (molybdenum carbide (MoC) target), a silicon (Si) target to which carbon (C) is added (silicon carbide (SiC) target), or the like. Alternatively, a hydrocarbon gas such as a methane (CH₄) gas as a carbon source can be formed by reactive sputtering used together with a rare gas.

When a layer containing a molybdenum nitride (MoN) or a layer containing a silicon nitride (SiN) is formed, the layer can be formed by reactive sputtering using a nitrogen-containing gas such as a nitrogen gas simultaneously with a rare gas.

Boron carbide (B₄C) target, a molybdenum (Mo) target added with boron (B) (a molybdenum boride (MoB) target), a silicon (Si) target added with boron (B) (a silicon boride (SiB) target), or the like can be used to form a layer containing boron (B).

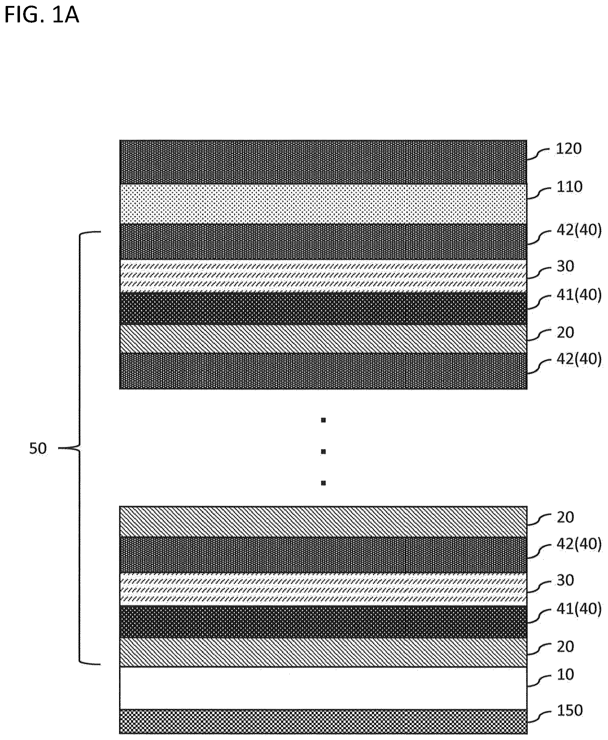

The multilayer reflective film 50 may be provided with the protective film 110 that protects the multilayer reflective film 50 (see FIGS. 1 to 7). As the material of the protective film 110, a material containing ruthenium (Ru) is preferably used. The protective film 110 is required to have a function of protecting the multilayer reflective film 50 from various dry etching and cleaning in the reflective photomask manufacturing process, an exposure environment at the time of using the reflective photomask, a cleaning process in a reproduction process after use, and the like, and a film containing an additive element such as niobium (Nb), zirconium (Zr), titanium (Ti), or rhodium (Rh) and having resistance to various processes is preferably used, and may have a multilayer structure formed by these materials.

The protective film 110 may be formed with another film interposed between the protective film and the multilayer reflective film 50, but is usually formed in contact with the multilayer reflective film 50.

The protective film 110 can be formed by, for example, a sputtering method. As the target, a ruthenium (Ru) target or a ruthenium (Ru) alloy target can be used to form a film or layer containing ruthenium (Ru), and a niobium (Nb) target or a niobium (Nb) alloy target can be used to form a film or layer containing niobium (Nb). Specifically, the target can be appropriately selected and used from a ruthenium (Ru) target, a niobium (Nb) target, an alloy target of ruthenium (Ru) and niobium (Nb), and the like. The protective film 110 (each layer constituting the protective film 110) can be formed by sputtering using a rare gas such as a neon (Ne) gas, an argon (Ar) gas, a krypton (Kr) gas, or a xenon (Xe) gas as a sputtering gas, or by reactive sputtering using a reactive gas such as an oxygen-containing gas, a nitrogen-containing gas, or a carbon-containing gas together with a rare gas. Specific examples of the reactive gas include nitrogen oxide gases such as an oxygen (O₂) gas, a nitrogen (N₂) gas, a nitrous oxide (N₂O) gas, a nitrogen monoxide (NO) gas, and a nitrogen dioxide (NO₂) gas, and carbon oxide gases such as a carbon monoxide (CO) gas and a carbon dioxide (CO₂) gas. The film thickness of the protective film 110 is not particularly limited, but is usually about 2 to 5 nm.

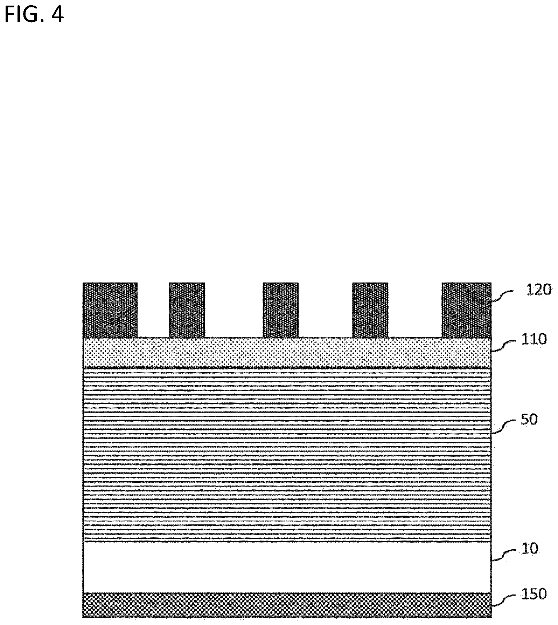

The reflective photomask blank of the present embodiment may further have an absorber film 120 that absorbs exposure light and functions as a pattern-formed film on the protective film 110 (see FIGS. 1 to 7). In general, a reflective photomask (EUV photomask) is manufactured by using a reflective photomask blank (EUV photomask blank) having the substrate 10, the multilayer reflective film 50, the protective film 110, and the absorber film 120, and patterning the absorber film 120 (see FIG. 4).

Specific examples of such a reflective photomask blank include one having the substrate 10, the multilayer reflective film 50 that is formed on one main surface of the substrate 10 and reflects exposure light, the protective film 110 formed on the multilayer reflective film 50, and the absorber film 120 that is formed on the protective film 110 and absorbs exposure light. From the reflective photomask blank having the multilayer reflective film 50, the protective film 110, and the absorber film 120, a reflective photomask having the substrate 10, the multilayer reflective film 50 that is formed on one main surface of the substrate 10 and reflects exposure light, the protective film 110 formed on the multilayer reflective film 50, and a pattern (absorber pattern) of the absorber film 120 that is formed on the protective film 110 and absorbs exposure light can be manufactured (see FIG. 4). The absorber film 120 is a film that absorbs exposure light, specifically, EUV light, and reduces reflectance.

There are no restrictions on the material of the absorber film 120, as long as it absorbs EUV light and can be patterned. Examples of the material of the absorber film 120 include a material containing tantalum (Ta) or chromium (Cr). In addition, the material containing Ta or Cr may contain oxygen (O), nitrogen (N), carbon (C), boron (B), or the like. Examples of the material containing tantalum (Ta) include tantalum (Ta) compounds such as a simple substance of Ta, TaO, TaN, TaON, TaC, TaCN, TaCO, TaCON, TaB, TaOB, TaNB, TaONB, TaCB, TaCNB, TaCOB, and TaCONB. Specific examples of the material containing chromium (Cr) include chromium compounds such as a simple substance of Cr, CrO, CrN, CrON, CrC, CrCN, CrCO, CrCON, CrB, CrOB, CrNB, CrONB, CrCB, CrCNB, CrCOB, and CrCONB.

The absorber film 120 can be formed by sputtering, and the sputtering is preferably magnetron sputtering. Specifically, it can be formed by sputtering using a metal target such as a chromium (Cr) target or a tantalum (Ta) target, or a metal compound target (target containing metal such as Cr and Ta, and oxygen (O), nitrogen (N), carbon (C), boron (B), and the like) such as a chromium compound target or a tantalum compound target, using a rare gas such as a neon (Ne) gas, an argon (Ar) gas, a krypton (Kr) gas, or a xenon (Xe) gas as a sputtering gas, or reactive sputtering using a reactive gas such as an oxygen-containing gas, a nitrogen-containing gas, or a carbon-containing gas together with a rare gas. The film thickness of the absorber film 120 is not particularly limited, but is usually about 40 to 80 nm.

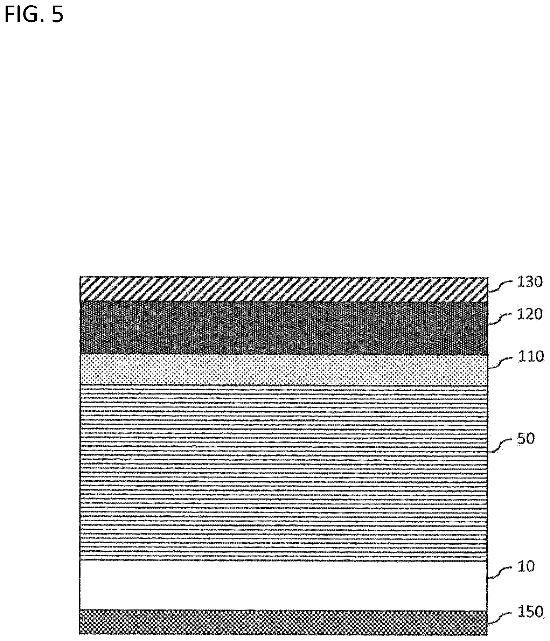

A hard mask film 130 (an etching mask film of the absorber film 120) having different etching characteristics from those of the absorber film 120 may be provided on the side of the absorber film 120 away from the substrate 10, preferably in contact with the absorber film 120 (see FIG. 5). The hard mask film 130 is a film that functions as an etching mask when the absorber film 120 is dry-etched. After the absorber pattern is formed, the hard mask film 130 may be removed so as not to remain on the reflective photomask, for example, as a part of the absorber film 120 while being left as a reflectance reduction layer for reducing the reflectance at the wavelength of light used in inspection such as pattern inspection. Examples of the material of the hard mask film 130 include a material containing chromium (Cr). The hard mask film 130 formed by a material containing Cr is particularly preferable in a case where the absorber film 120 is formed by a material containing Ta and not containing Cr. When a layer (reflectance reduction layer) mainly having a function of reducing the reflectance at the wavelength of light used in inspection such as pattern inspection is formed on the absorber film 120, the hard mask film 130 can be formed on the reflectance reduction layer of the absorber film 120. The hard mask film 130 can be formed by, for example, a magnetron sputtering method. The film thickness of the hard mask film 130 is not particularly limited, but is usually about 5 to 20 nm.

The reflective photomask blank may further be provided with a conductive film 150 used for electrostatically chucking the reflective photomask to the exposure device on another main surface (back side surface), which is a surface opposite to the one main surface of the substrate 10, preferably in contact with the other main surface (see FIGS. 1 to 7).

The conductive film 150 preferably has a sheet resistance of 100 Ω/A or less, and the material thereof is not particularly limited. Examples of the material of the conductive film 150 include a material containing tantalum (Ta) or chromium (Cr). In addition, the material containing tantalum (Ta) or chromium (Cr) may contain oxygen (O), nitrogen (N), carbon (C), boron (B), or the like. Examples of the material containing tantalum (Ta) include Ta alone and tantalum (Ta) compounds such as TaO, TaN, TaON, TaC, TaCO, TaCN, TaCON, TaB, TaOB, TaNB, TaONB, TaCB, TaCOB, TaCNB, and TaCONB. Specific examples of the material containing chromium (Cr) include Cr alone and chromium (Cr) compounds such as CrO, CrN, CrON, CrC, CrCO, CrCN, CrCON, CrB, CrOB, CrNB, CrONB, CrCB, CrCOB, CrCNB, and CrCONB.

The thickness of the conductive film 150 is not particularly limited as long as it functions for an electrostatic chuck, and is usually about 20 to 300 nm. The thickness of the conductive film 150 is preferably formed so that the film stress is balanced with the patterns (absorber patterns) of the multilayer reflective film 50 and the absorber film 120 after being formed as the reflective photomask, particularly after the pattern (absorber pattern) of the absorber film 120 is formed. The conductive film 150 may be formed before the multilayer reflective film 50 is formed, or may be formed after all the films on the multilayer reflective film 50 side of the substrate 10 are formed, or the conductive film 150 may be formed after a part of the film on the multilayer reflective film 50 side of the substrate 10 is formed, and then the remaining film on the multilayer reflective film 50 side of the substrate 10 may be formed. The conductive film 150 can be formed by, for example, a magnetron sputtering method.

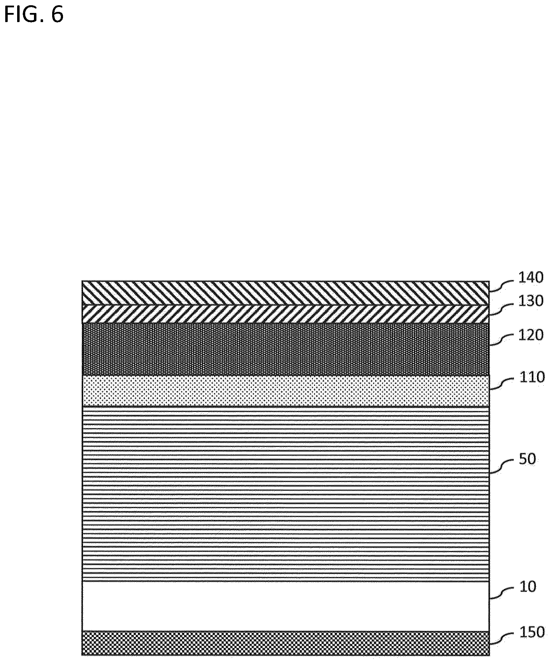

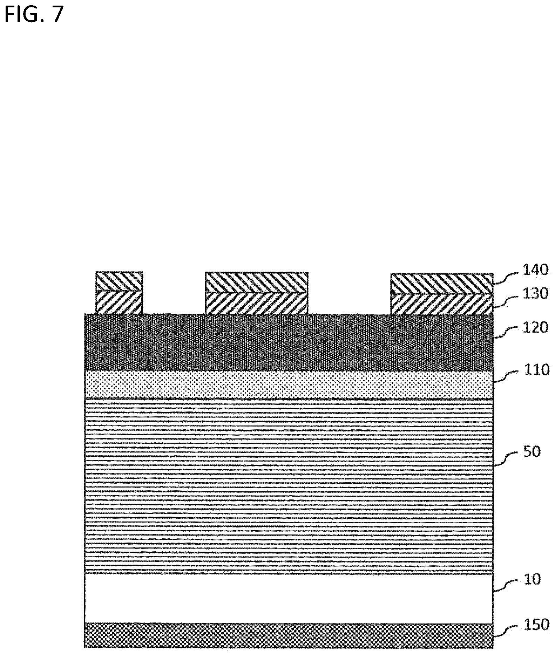

The reflective photomask blank may further have a resist film 140 formed on the side farthest from the substrate 10 (see FIG. 6). In the present embodiment, the resist film 140 is preferably an electron beam (EB) resist. Further, the resist film 140 is preferably removable by SPM cleaning. Note that FIG. 7 illustrates the patterned resist film 140 and hard mask film 130.

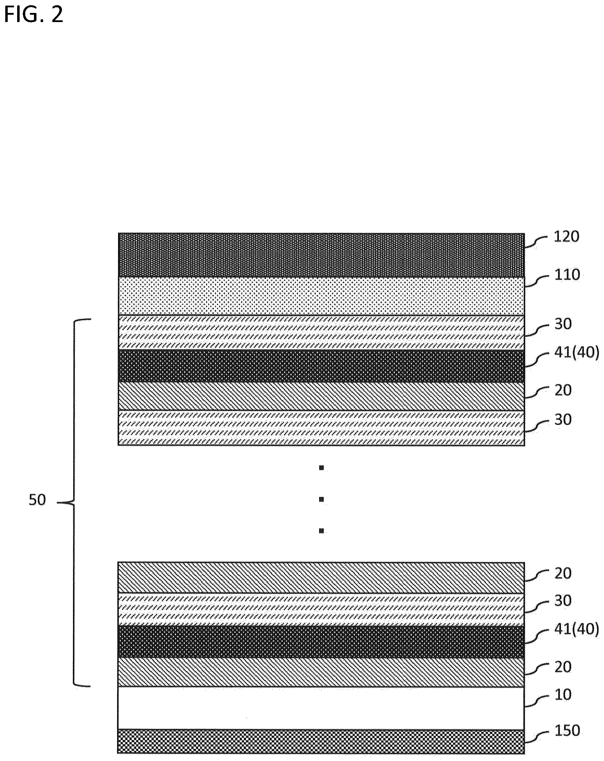

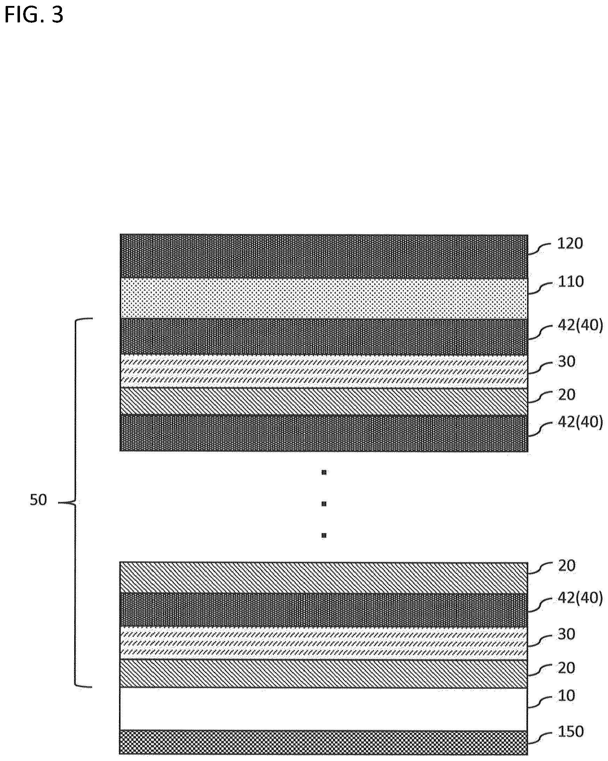

The multilayer reflective film 50 illustrated in FIGS. 4 to 7 can employ any aspect illustrated in FIGS. 1A, 1B, 2, and 3. That is, in the multilayer reflective film 50 illustrated in FIGS. 4 to 7, the high refractive index layer 20, the first diffusion prevention layer 41, the low refractive index layer 30, and the second diffusion prevention layer 42 may be provided as a repeating unit as illustrated in FIGS. 1A and 1B, the high refractive index layer 20, the first diffusion prevention layer 41, and the low refractive index layer 30 may be provided as a repeating unit as illustrated in FIG. 2, or the high refractive index layer 20, the low refractive index layer 30, and the second diffusion prevention layer 42 may be provided as a repeating unit as illustrated in FIG. 3.

### [Examples]

Examples and comparative examples are given below to describe the present invention in detail, but the present invention is not limited to the following examples.

### [Example 1]

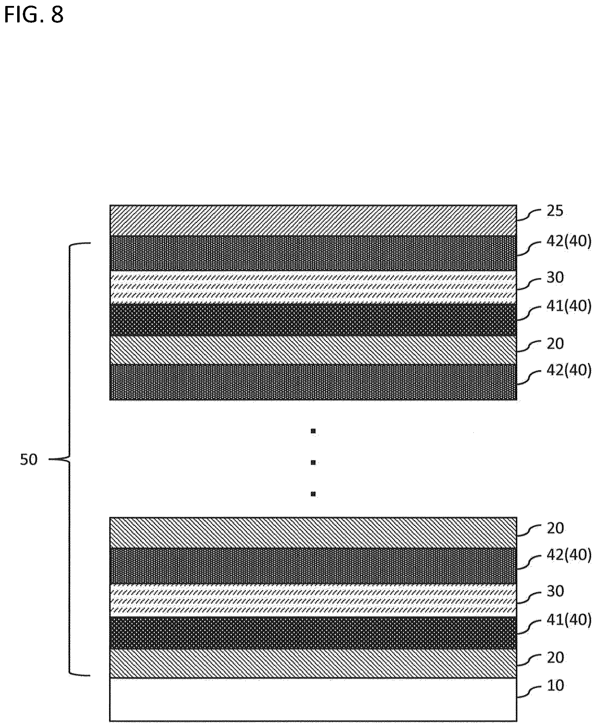

In Example 1, a sputtering apparatus capable of placing a 152 mm square, 6.35 mm thick low thermal expansion glass substrate (SiO2-TiO2 based glass substrate) as the substrate 10, mounting a plurality of targets and discharging the targets one by one or at the same time was used. The multilayer reflective film 50 was formed by DC magnetron sputtering while the main surfaces of the target and the substrate 10 were opposed to each other and the substrate 10 was rotated. Note that an aspect of Example 1 is illustrated in FIG. 8.

More specifically, a ruthenium (Ru) target and a silicon (Si) target were mounted in the sputtering apparatus, and the substrate 10 was placed thereon. First, power was applied to a silicon (Si) target while an argon (Ar) gas (flow rate: 12 SCCM) was caused to flow in a chamber, a silicon (Si) layer having a thickness of 3.5 nm was formed as the high refractive index layer 20, and the application of power to the silicon (Si) target was stopped. Next, power was applied to a silicon (Si) target while the argon gas (flow rate: 15 SCCM) and the nitrogen (N₂) gas (flow rate: 50 SCCM) were caused to flow in the chamber, a silicon nitride (SiN) layer having a thickness of 0.5 nm was formed as the first diffusion prevention layer 41 on the side of the low refractive index layer 30 close to the substrate 10, and the application of power to the silicon (Si) target was stopped. Next, power was applied to a ruthenium (Ru) target while the argon gas (flow rate: 15 SCCM) was caused to flow in the chamber, a ruthenium (Ru) layer having a thickness of 2.5 nm was formed as the low refractive index layer 30, and the application of power to the ruthenium (Ru) target was stopped. Next, power was applied to the silicon (Si) target while the argon gas (flow rate: 15 SCCM) and the nitrogen (N₂) gas (flow rate: 50 SCCM) were caused to flow in the chamber, a silicon nitride (SiN) layer having a thickness of 0.5 nm was formed as the second diffusion prevention layer 42 on the side of the low refractive index layer 30 away from the substrate 10, and the application of power to the silicon (Si) target was stopped. An operation of forming the high refractive index layer 20, the first diffusion prevention layer 41 on the side of the low refractive index layer 30 close to the substrate 10, the low refractive index layer 30, and the second diffusion prevention layer 42 on the side of the low refractive index layer 30 away from the substrate 10 was defined as one cycle, and this operation was repeated to form a periodic stacked structure. The number of repetitions of the periodic stacked structure was 40 cycles or 20 cycles. After the second diffusion prevention layer 42 on the side of the low refractive index layer 30 away from the substrate 10 in the last cycle was formed, finally, a silicon (Si) layer of 4 nm (indicated as a reference numeral 25 in FIG. 8) was formed as the uppermost layer of the multilayer reflective film 50 by the above method to obtain the multilayer reflective film 50.

As a result of measuring the EUV reflectance at a wavelength of 13.1 to 14 nm at an incident angle of six degrees for the obtained reflective photomask blank including the substrate 10 and the multilayer reflective film 50, the reflectance was maximized at 13.5 nm, and the value at the number of repetitions of 40 cycles of the periodic stacked structure was 62.6%. Further, the difference in reflectance (R40-R20) between the reflectance (R40) when the number of repetitions of the periodic stacked structure was 40 cycles and the reflectance (R20) when the number of repetitions was 20 cycles was 3.3%.

### [Example 2]

A periodic stacked structure was formed similarly to that in Example 1 except that a silicon (Si) layer having a thickness of 4 nm was formed as the high refractive index layer 20 and the second diffusion prevention layer 42 on the side of the low refractive index layer 30 away from the substrate 10 was not formed. The number of repetitions of the periodic stacked structure was 40 cycles or 20 cycles. The silicon (Si) layer of 4.5 nm was formed as the uppermost layer of the multilayer reflective film 50 to form the multilayer reflective film 50, and a reflective photomask blank including the substrate 10 and the multilayer reflective film 50 was obtained.

As a result of evaluating the EUV reflectance of the obtained reflective photomask blank by a method similar to that in Example 1, the reflectance was maximized at 13.5 nm, and the value thereof at the number of repetitions of the periodic stacked structure of 40 cycles was 62.1%. Further, the difference in reflectance (R40-R20) between the reflectance (R40) when the number of repetitions of the periodic stacked structure was 40 cycles and the reflectance (R20) when the number of repetitions was 20 cycles was 3.0%. A comparison with Example 1 indicates that the value of the reflectance (R40) is larger when the second diffusion prevention layer 42 is provided.

### [Example 3]

A reflective photomask blank was obtained with the number of repetitions of the periodic stacked structure being 20 cycles similarly to that in Example 1 except that, in a sputtering apparatus, a ruthenium (Ru) target, a silicon (Si) target, and a molybdenum (Mo) target were mounted, a silicon (Si) layer having a thickness of 4.5 nm was formed as the high refractive index layer 20, power was applied to the molybdenum (Mo) target while the argon gas (flow rate: 30 SCCM) was caused to flow in the chamber to form a molybdenum (Mo) layer having a thickness of 0.5 nm as the first diffusion prevention layer 41 on the side of the low refractive index layer 30 close to the substrate 10 and to form a ruthenium (Ru) layer having a thickness of 1.5 nm as the low refractive index layer 30, power was applied to the molybdenum (Mo) target while the argon gas (flow rate: 30 SCCM) was caused to flow in the chamber as the second diffusion prevention layer 42 on the side of the low refractive index layer 30 away from the substrate 10 to form a molybdenum (Mo) layer having a thickness of 0.5 nm, and a silicon (Si) layer having a thickness of 4.5 nm was formed as the uppermost layer of the multilayer reflective film 50 on the second diffusion prevention layer 42 on the side of the low refractive index layer 30 away from the substrate 10 in the last cycle.

When the EUV reflectance of the obtained reflective photomask blank was measured by a method similar to that in Example 1, the reflectance was maximum at 13.5 nm, and the value thereof was 60.2%.

### [Example 4]

A reflective photomask blank was obtained similarly to that in Example 3 except that power was applied to the molybdenum (Mo) target while the argon gas (flow rate: 15 SCCM) and the nitrogen gas (flow rate: 50 SCCM) were caused to flow in the chamber to form a molybdenum nitride (MoN) layer having a thickness of 0.5 nm as the first diffusion prevention layer 41 on the side of the low refractive index layer 30 close to the substrate 10, and power was applied to the molybdenum (Mo) target while the argon gas (flow rate: 15 SCCM) and the nitrogen gas (flow rate: 50 SCCM) were caused to flow in the chamber to form a molybdenum nitride (MoN) layer having a thickness of 0.5 nm as the second diffusion prevention layer 42 on the side of the low refractive index layer 30 away from the substrate 10.

As a result of evaluating the EUV reflectance of the obtained reflective photomask blank by a method similar to that in Example 1, the reflectance was maximized at 13.5 nm, and the value thereof was 59.7%.

### [Example 5]

A reflective photomask blank was obtained similarly to that in Example 3 except that a molybdenum carbide (MoC) target was used instead of the molybdenum (Mo) target, and power was applied to the molybdenum carbide (MoC) target while the argon gas (flow rate: 30 SCCM) was caused to flow in the chamber to form a molybdenum carbide (MoC) layer having a thickness of 0.5 nm as the first diffusion prevention layer 41 on the side of the low refractive index layer 30 close to the substrate 10, and power was applied to the molybdenum carbide (MoC) target while the argon gas (flow rate: 30 SCCM) was caused to flow in the chamber to form a molybdenum carbide (MoC) layer having a thickness of 0.5 nm as the second diffusion prevention layer 42 on the side of the low refractive index layer 30 away from the substrate 10.

As a result of evaluating the EUV reflectance of the obtained reflective photomask blank by a method similar to that in Example 1, the reflectance was maximized at 13.5 nm, and the value thereof was 61.2%.

### [Examples 6 to 8]

A periodic stacked structure was formed similarly to that in Example 1 except that a ruthenium (Ru) target, a silicon (Si) target, and a molybdenum (Mo) target were mounted in the sputtering apparatus, and power was applied to the ruthenium (Ru) target and the molybdenum (Mo) target while the argon gas (flow rate: 15 SCCM) was caused to flow in the chamber to form a ruthenium molybdenum (RuMo) alloy layer having a thickness of 2.5 nm as the low refractive index layer 30. The composition ratio (Ru: Mo) of ruthenium (Ru) to molybdenum (Mo) in the ruthenium molybdenum (RuMo) alloy layer was 3:1 in Example 6, 1:1 in Example 7, and 1:3 in Example 8. The number of repetitions of the periodic stacked structure was 40 cycles or 20 cycles. A silicon (Si) layer of 4 nm was formed as the uppermost layer of the multilayer reflective film 50 by the above-described method to form the multilayer reflective film 50, and a reflective photomask blank including the substrate 10 and the multilayer reflective film 50 was obtained.

As a result of evaluating the EUV reflectance of the obtained reflective photomask blank by a method similar to that in Example 1, the reflectance was maximized at 13.5 nm, and the value when the number of repetitions of the periodic stacked structure was 40 cycles was 64.0% in Example 6, 62.1% in Example 7, and 61.2% in Example 8. Further, the difference in reflectance (R40-R20) between the reflectance (R40) when the number of repetitions of the periodic stacked structure was 40 cycles and the reflectance (R20) when the number of repetitions was 20 cycles was 4.7% in Example 6, 5.7% in Example 7, and 7.4% in Example 8. A comparison between Example 1 and Examples 6 to 8 indicates that the higher the ruthenium (Ru) content of the low refractive index layer 30, the smaller the difference between the reflectance at 40 cycles and the reflectance at 20 cycles, and thus the contribution of reflection from a position shallower than the surface of the multilayer reflective film 50 becomes relatively large. In particular, it is illustrated that in Examples 1 and 6 in which the ruthenium (Ru) content is equal to or more than 70 at%, the reflectance at 20 cycles is high.

### [Examples 9 to 12]

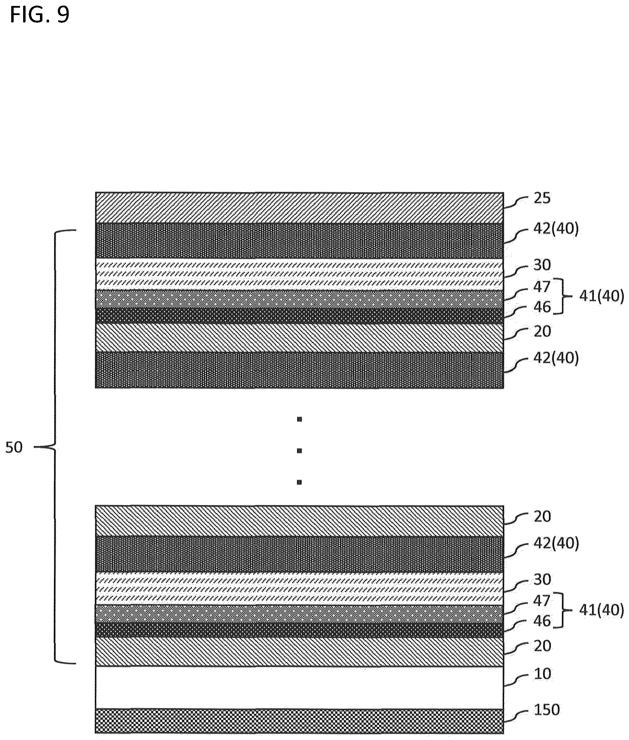

A ruthenium (Ru) target, a silicon (Si) target, and a molybdenum (Mo) target were mounted in the sputtering apparatus, and the substrate 10 was placed thereon. First, power was applied to the silicon (Si) target while the argon (Ar) gas (flow rate: 12 SCCM) was caused to flow in the chamber, a silicon (Si) layer having a thickness of 4 nm was formed as the high refractive index layer 20, and the application of power to the silicon (Si) target was stopped. Next, power was applied to the silicon (Si) target while the argon gas (flow rate: 15 SCCM) and the nitrogen (N₂) gas (flow rate: 50 SCCM) were caused to flow in the chamber, a silicon nitride (SiN) layer having a thickness of 0.5 nm was formed as the first sublayer 46 of the first diffusion prevention layer 41 on the side of the low refractive index layer 30 close to the substrate 10, and the application of power to the silicon (Si) target was stopped. Next, power was applied to the molybdenum (Mo) target while the argon gas (flow rate: 30 SCCM) was caused to flow in the chamber, a molybdenum (Mo) layer was formed as the second sublayer 47 of the first diffusion prevention layer 41 on the side of the low refractive index layer 30 close to the substrate 10, and the application of power to the molybdenum (Mo) target was stopped. Next, power was applied to the ruthenium (Ru) target while the argon gas (flow rate: 15SCCM) was caused to flow in the chamber, a ruthenium (Ru) layer was formed as the low refractive index layer 30, and the application of power to the ruthenium (Ru) target was stopped. Next, power was applied to the molybdenum (Mo) target while the argon gas (flow rate: 30 SCCM) was caused to flow in the chamber, a molybdenum (Mo) layer was formed as the second diffusion prevention layer 42 on the side of the low refractive index layer 30 away from the substrate 10, and the application of power to the molybdenum (Mo) target was stopped. Note that an aspect of Examples 9 to 12 is illustrated in FIG. 9.

The thickness of the second sublayer 47 (molybdenum (Mo) layer) of the first diffusion prevention layer 41 on the side of the low refractive index layer 30 close to the substrate 10 was 0.2 nm in Example 9, 0.5 nm in Example 10, 0.8 nm in Example 11, and 1 nm in Example 12.

The thickness of the low refractive index layer 30 (ruthenium (Ru) layer) was 2.1 nm in Example 9, 1.5 nm in Example 10, 0.9 nm in Example 11, and 0.5 nm in Example 12.

The thickness of the second diffusion prevention layer 42 (molybdenum (Mo) layer) on the side of the low refractive index layer 30 away from the substrate 10 was 0.2 nm in Example 9, 0.5 nm in Example 10, 0.8 nm in Example 11, and 1 nm in Example 12.

The operation of forming the high refractive index layer 20, the first sublayer 46 of the first diffusion prevention layer 41 on the side of the low refractive index layer 30 close to the substrate 10, the second sublayer 47 of the first diffusion prevention layer 41 on the side of the low refractive index layer 30 close to the substrate 10, the low refractive index layer 30, and the second diffusion prevention layer 42 on the side of the low refractive index layer 30 away from the substrate 10 was taken as one cycle, and repeated to form a periodic stacked structure. The number of repetitions of the periodic stacked structure was 40 cycles or 20 cycles. After the second diffusion prevention layer 42 on the side of the low refractive index layer 30 away from the substrate 10 in the last cycle was formed, finally, a silicon (Si) layer of 4.5 nm (indicated as a reference numeral 25 in FIG. 9) was formed as the uppermost layer of the multilayer reflective film 50 by the above-described method to form the multilayer reflective film 50, and a reflective photomask blank including the substrate 10 and the multilayer reflective film 50 was obtained.

As a result of evaluating the EUV reflectance of the obtained reflective photomask blank by a method similar to that in Example 1, the reflectance was maximized at 13.5 nm, and the value at the number of repetitions of the periodic stacked structure of 40 cycles was 65.1% in Example 9, 66.5% in Example 10, 66.9% in Example 11, and 66.0% in Example 12. Further, the difference in reflectance (R40-R20) between the reflectance (R40) when the number of repetitions of the periodic stacked structure was 40 cycles and the reflectance (R20) when the number of repetitions was 20 cycles was 3.7% in Example 9, 4.9% in Example 10, 6.0% in Example 11, and 8.2% in Example 12.

From a comparison of Examples 2 and 9 to 12, it can be seen that the larger the thickness of the molybdenum layer of the diffusion prevention layer 40, the larger the difference between the reflectance at 40 cycles and the reflectance at 20 cycles, and thus the contribution of reflection from a position shallower than the surface of the multilayer reflective film 50 becomes relatively small.

In addition, by setting both of the thickness of the second sublayer 47 (molybdenum (Mo) layer) of the first diffusion prevention layer 41 on the side of the low refractive index layer 30 close to the substrate 10 and the thickness of the second diffusion prevention layer 42 (molybdenum (Mo) layer) on the side of the low refractive index layer 30 away from the substrate 10 to be equal to or more than 0.2 nm and equal to or less than 0.8 nm, both the reflectance of the periodic structure of 20 cycles and the reflectance of the periodic structure of 40 cycles become particularly high values, contribution of reflection from a shallower position from the surface of the multilayer reflective film 50 can be increased, and the effect of preventing diffusion between layers is high.

### [Comparative Example 1]

A periodic stacked structure was formed similarly to that in Example 1 except that a silicon (Si) layer having a thickness of 4.5 nm was formed as the high refractive index layer 20, the first diffusion prevention layer 41 on the side of the low refractive index layer 30 close to the substrate 10 was not formed, and the second diffusion prevention layer 42 on the side of the low refractive index layer 30 away from the substrate 10 was not formed. The number of repetitions of the periodic stacked structure was set to 40 cycles. The silicon (Si) layer of 4.5 nm was formed as the uppermost layer of the multilayer reflective film 50 to form the multilayer reflective film 50, and a reflective photomask blank including the substrate 10 and the multilayer reflective film 50 was obtained.

As a result of evaluating the EUV reflectance of the obtained reflective photomask blank by a method similar to that in Example 1, the reflectance was maximized at 13.5 nm, and the value thereof was 58.7% in Comparative Example 1. As described above, when the diffusion prevention layer 40 was not provided, the reflectance was a low value. From a comparison of Examples 1, 3, 4 and 5 with Comparative Example 1, it can be recognized that the silicon nitride (SiN) layer, the molybdenum (Mo) layer, the molybdenum nitride (MoN) layer, and the molybdenum carbide (MoC) layer are improved in reflectance due to their diffusion-preventing effect.

### [Comparative Example 2]

A periodic stacked structure was formed similarly to that in Example 2 except that a molybdenum (Mo) target and a silicon (Si) target were attached to the sputtering apparatus, and power was applied to the molybdenum (Mo) target while the argon gas (flow rate: 15 SCCM) was caused to flow in the chamber to form a molybdenum (Mo) layer having a thickness of 2.5 nm as the low refractive index layer 30. The silicon (Si) layer of 4.5 nm was formed as the uppermost layer of the multilayer reflective film 50 to form the multilayer reflective film 50, and a reflective photomask blank including the substrate 10 and the multilayer reflective film 50 was obtained.

The difference in reflectance (R40-R20) of the obtained reflective photomask blank between the reflectance (R40) when the number of repetitions of the periodic stacked structure was 40 cycles and reflectance (R20) when the number of repetitions was 20 cycles was evaluated by a method similar to that in Example 1, and the result was 11.7%.

The fact that the difference between the reflectance of 40 cycles of repetition and the reflectance of 20 cycles of the periodic stacked structure of Comparative Example 2 is relatively large means that contribution of reflection from a position shallower than the surface of the multilayer reflective film 50 is relatively small. On the other hand, in the periodic stacked structure of Example 2, it is indicated that the difference between the reflectance of 40 cycles and the reflectance of 20 cycles is relatively small, and contribution of reflection from a position shallower than the surface of the multilayer reflective film 50 is relatively large.

### Reference Signs List

- 10: Substrate
- 20: High refractive index layer
- 30: Low refractive index layer
- 40: Diffusion prevention layer
- 41: First diffusion prevention layer
- 42: Second diffusion prevention layer
- 46: First sublayer
- 47: Second sublayer
- 50: Multilayer reflective film

## Claims

1. A reflective photomask blank comprising:
a substrate; and
a multilayer reflective film that is formed on one main surface of the substrate and reflects exposure light,
wherein the multilayer reflective film has a periodic stacked structure in which a low refractive index layer containing ruthenium (Ru), a high refractive index layer containing silicon (Si), and a diffusion prevention layer that prevents mutual diffusion of ruthenium (Ru) and silicon (Si) are periodically stacked,
wherein the diffusion prevention layer is formed in contact with the low refractive index layer on both or one of a side of the low refractive index layer close to the substrate and a side of the low refractive index layer away from the substrate, and
wherein the diffusion prevention layer is one or more sublayers selected from a layer containing a silicon nitride (SiN), a layer containing silicon carbide (SiC), a layer containing molybdenum (Mo), a layer containing a molybdenum nitride (MoN), and a layer containing molybdenum carbide (MoC).

2. The reflective photomask blank according to claim 1, wherein the low refractive index layer has a ruthenium content equal to or more than 70 at%.

3. The reflective photomask blank according to claim 1 or 2,
wherein the diffusion prevention layer has a first diffusion prevention layer provided in contact with the side of the low refractive index layer close to the substrate,
wherein the first diffusion prevention layer has a first sublayer formed in contact with the high refractive index layer and a second sublayer formed in contact with the low refractive index layer,
wherein the first sublayer is a sublayer containing at least one material selected from a silicon nitride (SiN), silicon carbide (SiC), a molybdenum nitride (MoN), and molybdenum carbide (MoC),
wherein the second sublayer is a sublayer containing molybdenum (Mo), and
wherein the second sublayer has a thickness between 0.2 nm and 0.8 nm.

4. The reflective photomask blank according to claim 3,
wherein the diffusion prevention layer has a second diffusion prevention layer provided in contact with a side of the low refractive index layer away from the substrate, and
wherein the second diffusion prevention layer has a layer containing molybdenum (Mo) formed in contact with the low refractive index layer, and a thickness of the second diffusion prevention layer is between 0.2 nm and 0.8 nm.

5. A method for manufacturing a reflective photomask blank comprising: forming the multilayer reflective film of the reflective photomask blank according to any one of claims 1 to 4 by a sputtering film formation method using a sputtering apparatus capable of mounting a plurality of targets in a chamber.
